(19) Europäisches Patentamt

European Patent Office

Office européen des brevets

(11) **EP 1 447 936 A1**

(12) **EUROPEAN PATENT APPLICATION**

(43) Date of publication:
**18.08.2004 Bulletin 2004/34**

(51) Int Cl.$^7$: **H04L 1/18**, H04L 1/00, H03M 13/00

(21) Application number: **03290328.8**

(22) Date of filing: **11.02.2003**

(84) Designated Contracting States:
**AT BE BG CH CY CZ DE DK EE ES FI FR GB GR HU IE IT LI LU MC NL PT SE SI SK TR**
Designated Extension States:
**AL LT LV MK RO**

(71) Applicant: **Motorola Inc.**
**Schaumburg, IL 60196 (US)**

(72) Inventors:
• **Vivier, Guillaume**
  **75013 Paris (FR)**
• **Sesia, Stefania**
  **92614 Antony (FR)**

• **Caire, Giuseppe**
  **06410 Biot (FR)**

(74) Representative: **Wharmby, Martin Angus**
**Motorola Centre de Recherche,**
**Parc Technologique de St. Aubin,**
**Route de L'Orme au Merisier,**
**Immeuble Columbia**
**91190 Gif-sur-Yvette (FR)**

Remarks:
Amended claims in accordance with Rule 86 (2) EPC.

(54) **Data communication unit and method thereof for iterative decoding**

(57)    A method (400) for receiving one or more data blocks in a data communication system comprises the step of receiving one or more data blocks at a receiving communication unit. The method further comprises the steps of determining (410) a-priori whether an iterative decoding operation of the one or more received data blocks is likely to converge; and requesting (420), by said receiving unit in response to determining that an iterative decoding operation is unlikely to converge, a re-transmission of said one or more data blocks. A communication unit and a communication system are also provided.

In this manner, the method prevents a receiver from performing wasteful (in a processing power and/or time sense) iterative decoding operations. Moreover, the overall delay in the receiver is also improved.

FIG. 4

## EP 1 447 936 A1

### Description

### Field of the Invention

This invention relates to decoding of data in communication units, and particularly to communication units supporting packet data transmissions. The invention is applicable to, but not limited to, speeding up an iterative decoding algorithm of compound codes.

### Background of the Invention

Third generation wireless systems, presently being designed for implementation in the near future, have as a requirement the support of speech and data. Different types of data services will be available with different Quality of Service (QoS) requirements, particularly in terms of error rate and delay.

Typically, these services can be divided into two groups, real-time and non-real-time. The real-time services typically require a low average data packet delay, arranged such that they can cope with a certain error rate. On the other hand, the non-real-time services typically require some limitation against delay, but often need a very low error rate.

Real-time services have been traditionally used only with Forward Error Correction (FEC) mechanisms that guarantee a bounded delay but deliver data with an error rate depending on channel conditions (which in wireless channels is highly variable). However, these services can only operate up to a maximum error rate. When this error-rate value is exceeded, even with a low delay, the service is not delivered.

In the field of this invention, it is known to use various data correction mechanisms to minimise the error rate. In particular, for wireless communication systems, convolutional codes are well known and are widely used. Recently, a novel class of FEC data packet (data block) transmissions, referred to as compound codes, such as 'turbo-codes' and 'Low Density Parity Check' (LDPC) codes, have appeared. These codes offer very good protection for an acceptable complexity and outperform all classical coding schemes. One of the key features of compound codes, that enable the codes to achieve a remarkable performance, is the use of iterative decoding. Iterative decoding is where the received information is processed several times by the same decoder, with the exchange of soft information performed between successive iterations. After each iteration, the coding performance improves until the decoding process converges to a correctly received and decoded data stream.

However, clearly when the signal to noise ratio (SNR) of the received data is too low, the decoder is unable to correctly decode the received codeword, irrespective of the number of iterations employed. In such situations, the decoder wastes time and power on continuing with the iterative decoding process is a vain and ultimately fruitless attempt to decode the codeword, i.e. the packet to be decoded by the receiver, until a decision is finally made that the codeword must be retransmitted.

A first known correction mechanism, for correcting received data packets corrupted during transmission, uses only forward error correction (FEC) coding. However, although an FEC mechanism guarantees a low delay and low delay variation, it cannot guarantee a low error rate.

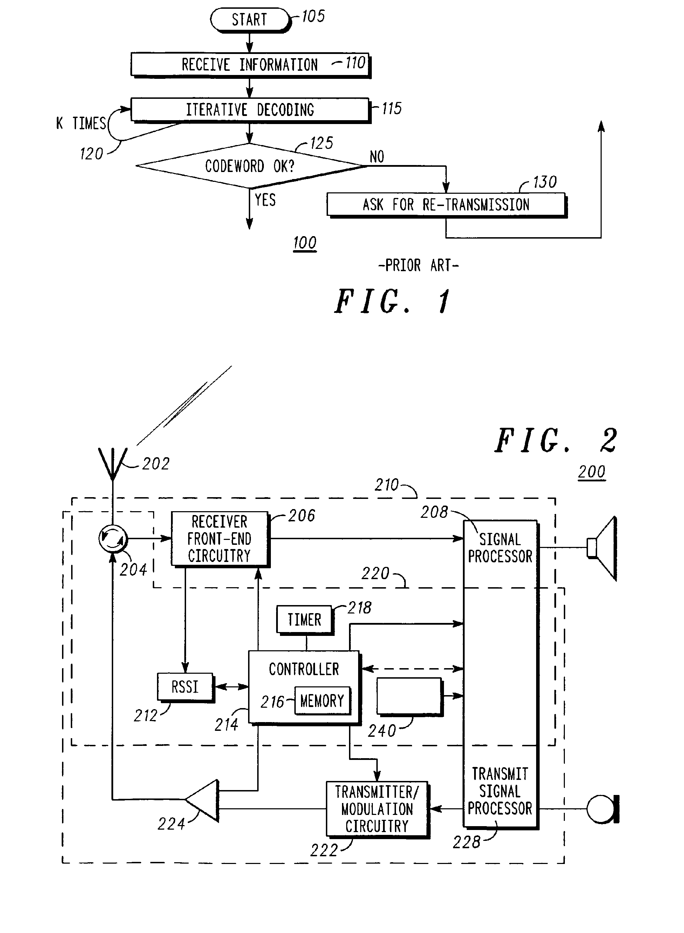

A second known correction mechanism uses re-transmission of erroneous data packets, as illustrated in FIG. 1. The re-transmission process is achieved via a feedback channel from the receiver to the transmitter, which is used to indicate whether the data packet has been correctly received or not. This correction mechanism is termed Automatic Repeat reQuest (ARQ) and is widely used in wired communication systems since it provides an error rate as low as needed.

As shown in FIG. 1, the ARQ re-transmission process commences by receiving digital information, in step 105. Iterative decoding is then applied to the received information in step 110. The iterative decoding process, as the name suggests, is applied a number (k) times, until the decoding operation converges to yield recovered data. If, after k times, the codeword has not been accurately decoded, in step 115, the process requests a re-transmission of the information, in step 120.

When ARQ is used over a wireless channel, which typically encounters a much higher data packet error rate, an ARQ mechanism often leads to very poor transmission performance. For instance, this poor performance results from, say, the same data packet requiring a large number of re-transmissions to be successfully received. To mitigate this effect, ARQ is usually used with a limited maximum number of re-transmissions, which bounds the delay but does not guarantee the error rate.

FEC used alone does not guarantee the delivered packet error rate, whereas ARQ with an unlimited number of re-transmissions does not provide a bounded delay. As a result, FEC and ARQ are often used jointly. This is commonly referred to as Hybrid ARQ (H-ARQ). H-ARQ is known as an efficient mechanism to provide error-free or low error rate transmissions in a wireless system, where the information flow is segmented into data packets.

A further known mechanism whose performance is determined by a re-transmission methodology is incremental redundancy (IR). In IR schemes, the first transmission is made using a very high coding rate, i.e. little error correction information is transmitted. Hence, as is often the case, the first reception is likely to be unsuccessful. Subsequently, additional error correction information is transmitted and combined with the previous information in order to increase the probability of successful decoding.

It is known that all linear codes can be represented in a graphical context, with iterative coding such as Turbo codes and LDPC predominantly being represented in this manner. A graphical representation helps to model the iterative decoding process by highlighting the evolution of the soft information between the nodes of the graph. However, graphical representation of codes is more suitable for infinite length codes, where the codes are analytically tractable if some approximations are made.

A need therefore exists for an improved decoding mechanism, which reduces a complexity in the iterative decoding process, for example when the decoding operation using Turbo codes or LDPC and can be represented graphically.

**Statement of Invention**

In accordance with the present invention, there is provided a method for receiving one or more data blocks, a data communication system and a data communication unit, as defined in the appended Claims.

**Brief Description of the Drawings**

FIG. 1 illustrates a flowchart of a classical re-transmission decoding process.

Exemplary embodiments of the present invention will now be described, with reference to the accompanying drawings, in which:

FIG. 2 illustrates a wireless digital communication unit adapted in accordance with a preferred embodiment of the present invention;

FIG. 3 illustrates a block diagram of an iterative decoder adapted in accordance with a preferred embodiment of the present invention;

FIG. 4 illustrates a flowchart of the proposed re-transmission process for a generic decoder, adapted according to the preferred embodiment of the present invention;

FIG. 5 illustrates a graphical representation of a Density Evolution process utilised in the preferred embodiment of the present invention;

FIG. 6 illustrates a further graphical representation of a Density Evolution process utilised in the preferred embodiment of the present invention; and

FIG. 7 illustrates a flowchart of the proposed re-transmission process when applied to an incremental redundancy decoder, according to the preferred embodiment of the present invention.

**Description of Preferred Embodiment**

Referring now to FIG. 2, there is shown a block diagram of a wireless digital communication unit, for example a third generation cellular subscriber unit, hereinafter referred to as user equipment (UE) 200, which is adapted to support the inventive concepts of the preferred embodiments of the present invention. As known in the art, and replicated here for completeness, the UE 200 comprises, for example, standard radio frequency (RF) components and circuits, such as an antenna 202 preferably coupled to an antenna switch 204 for receiving a digitally modulated RF signal. The antenna switch 204 provides isolation between a receiver and a transmitter chain within the UE 200. The receiver chain typically includes receiver front-end circuitry 206 (effectively providing reception, filtering and intermediate or baseband frequency conversion). The front-end circuitry 206 is serially coupled to a signal processing function 208 to convert, inter-alia, the received digitised signal into blocks of data for subsequent processing. An output from the signal processing function is provided to a suitable output device 210, such as a speaker.

In accordance with the preferred embodiment of the invention, the signal processor function 208, which may be a baseband (back-end) signal processing receiver integrated circuit in other embodiments, has been adapted to incorporate the inventive concepts described below. In practice, the signal processing function 208, in the context of the present invention, will perform numerous signal processing tasks, such as: symbol timing recovery, demodulation, decoding, burst building, de-multiplexing, de-interleaving, re-ordering, etc.

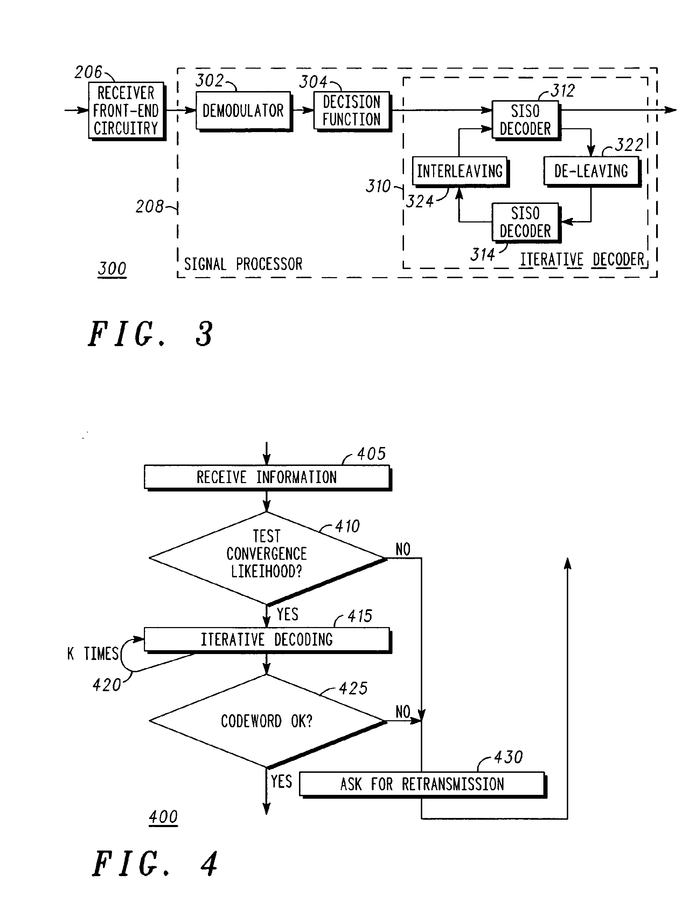

In particular, the decoding function in the signal processing function 208 has been adapted to include a prior decision function as to whether the iterative decoding operation will likely converge. If it is determined that the subsequent iterative decoding operation will likely converge, the decoding operation is performed. However, and advantageously, if it is determined that the subsequent iterative decoding operation will be unlikely to converge, the iterative decoding operation is not performed and a re-transmission of the data blocks requested. Preferably, the signal processing function 208 has been adapted to perform, or be replaced in software hardware or firmware by, an iterative decoder function as described further below with reference to FIG. 3.

For completeness, the receiver chain also includes received signal strength indicator (RSSI) circuitry 212 coupled to the receiver front-end circuitry 206 and the signal processing function 208 (generally realised by a digital signal processor (DSP)). A controller 214, also coupled to the receiver front-end circuitry 206 and the signal processing function 208, may therefore receive bit error rate (BER) or frame error rate (FER) data from recovered information. The controller 214 is coupled to the memory device 216 for storing operating regimes, such as decoding/encoding functions and the like. A timer 218 is typically coupled to the controller 214 to control the timing of operations (transmission or reception of time-dependent signals) within the UE 200. In the context of the present invention, the timer 218 dictates the timing of speech signals, in the transmit (encoding) path and/or the receive (decoding) path.

As regards the transmit chain, as also known in the art, this essentially includes an input device, such as a microphone transducer coupled in series via transmit signal processor 228 to a transmitter/ modulation circuit 222. Thereafter, any transmit signal is passed through a power amplifier 224 to be radiated from the antenna 202. The transmitter/ modulation circuitry 222 and the power amplifier 224 are operationally responsive to the controller, with an output from the power amplifier coupled to the duplex filter or circulator 204. The transmitter/ modulation circuitry 222 and receiver front-end circuitry 206 comprise frequency up-conversion and frequency down-conversion functions (not shown).

The various adapted components within a UE 200 (or other iterative decoding communication unit) can be realised in discrete or integrated component form. More generally, the functionality associated with deciding whether to decode or not may be implemented in a respective communication unit in any suitable manner. For example, new apparatus may be added to a conventional Node-B or UE, or alternatively existing parts of a conventional communication unit may be adapted, for example by reprogramming one or more processors therein. As such, the required adaptation, for example the incorporation of a decision function to determine the likelihood of convergence of the iterative decoding process, may be implemented in the form of processor-implementable instructions stored on a storage medium, such as a floppy disk, hard disk, PROM, RAM or any combination of these or other storage media.

Referring now to FIG. 3, a preferred embodiment of the present invention is described. A front-end receiver 206 receives a digital information signal and routes it to a demodulator 302. In accordance with the preferred embodiment of the present invention, after demodulation of the received digital information signal, a determination is made, in decision function 304, as to whether it is likely that the iterative decoding operation will converge. Advantageously, the proposed technique prevents running the iterative decoder 310 when the test detects a-priori that the iterative decoder 310 cannot decode the demodulated information correctly.

If, based on the demodulated information, it is deemed likely that the iterative decoding function 10 is performed. In this embodiment of the present invention, the iterative decoding function 310 comprises, for instance, Peral's Belief Propagation (BP) algorithm. This is the basis of soft-input soft-output (SISO) decoders 312, 314, forward-backward decoders, etc., and is therefore applicable to all general cases where iterative decoding is possible. As known in the art, the SISO decoders 312, 314 are separated by a de-leaving function 322 and an interleaving function 324 to reformulate and formulate the data stream for the decoding operation. Interleaving is used to avoid burst errors having an independent identically distributed (IID) error statistic, which makes it easier for the data stream to be treated. The de-interleaving function is the reverse process, aiming to restore the sequence in the original order.

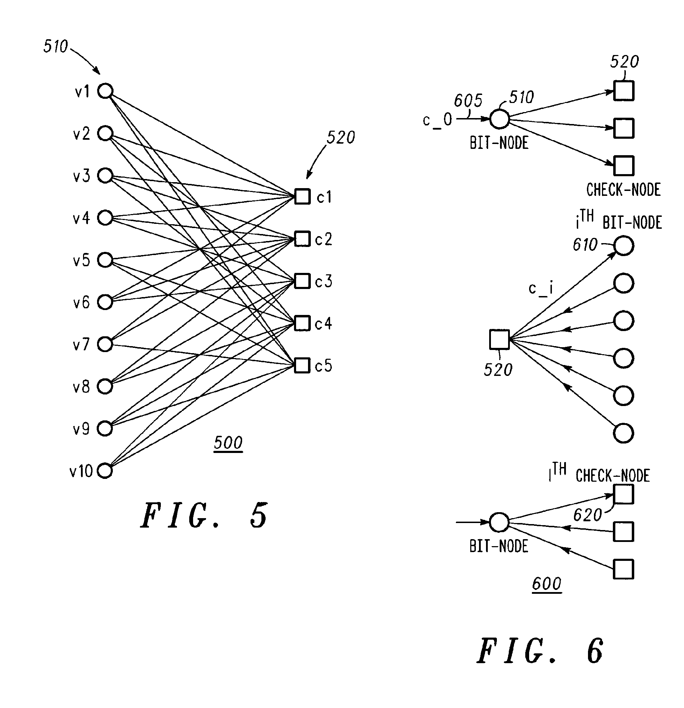

The preferred process is illustrated in the flowchart 400 FIG. 4. The ARQ re-transmission process commences by receiving information, in step 405. Notably, in accordance with the preferred embodiment of the present invention, an iterative decoding 'convergence likelihood' test is performed, as shown in step 410. The details of the preferred 'convergence likelihood' test are further described in relation to FIG. 5 and FIG. 6. If the determination of the convergence likelihood test yields that iterative decoding will be unlikely to converge, in step 410, an immediate request for re-transmission is sent to the transmitting unit, as shown in step 430.

However, if the determination of the convergence likelihood yields that iterative decoding will likely converge, in step 410, iterative decoding is then applied to the received information in step 415. The iterative decoding, as the name suggests, is applied a number (k) times, until the decoding converges, as shown in step 420. If, after k times, the codeword has not been accurately decoded, in step 425, the process requests a re-transmission of the information, in step 430.

In accordance with the preferred embodiment of the present invention, the determination as to whether a decoding operation of a received information signal will converge is based on an analysis of the Density Evolution (DE) of the demodulated data. A graphical representation 500 of this is shown in FIG. 5, where bit-nodes 510 represent the bits of the codeword and the check-nodes 520 represent the parity check equations that the bit-nodes are related to. The illustrated graphical representation of Density Evolution uses a regular LDPC Code (3,6), where each bit-node 510 is connected to three check-nodes 520 and each check-node 520 is connected to six bit-nodes 510.

The messages applied to a DE function are distributed usually in a manner similar to a Gaussian response. Thus, by applying a Gaussian approximation, it is possible to propagate a one-dimensional parameter through the graph, i.e. describing the density instead the density of the messages itself. It is known that this parameter can be the mean of the density or the mutual information. In the following description of DE, the term 'message' identifies the parameter selected for propagation through the graph, for example mutual information or a mean of the probability density distribution of the original LLR message.

Referring now to FIG. 6, an example of the DE process 600 is illustrated graphically, where a message $(c\_0)$ 605 is received from the demodulator. In this context, DE is used as a method to evaluate the performance of the real BP decoder. A bit-node 'i' 610 will be connected to a check-node k, if this bit-node participates in the $k^{th}$ parity check equation.

The real BP decoder operates in the following manner. Upon a first iteration, an initial message 605 is associated to each bit-node 510, related to the output of the channel. Each bit-node 510 (with one bit-node shown for clarity purposes only) sends the initial message (in a log-likelihood ratio (LLR) form), identified as $v\_k$, to all the corresponding check-nodes that the bit-node 510 is connected to, where k is the index identifying the respective bit-node 510. After processing the initial message, each check-node returns a message to the respective bit-nodes that it is connected to.

Suppose that the set of bit-nodes connected to this check-node is S={s1, s2, ... .sdc}. It is necessary to compute the message that the check-node sends to the $i^{th}$ bit-node (where 'i' $\in$ (1, ...dc)). Here, the message $c\_i$ will be a function of the incoming message from all the bit-nodes except from the message sent by the bit-node 'i', that is:

$$c\_i = f (v\_s1, v\_s2, ..v\_\{si\text{-}1\},v\_\{si\text{+}1\},.v\_sdc) \qquad [1]$$

Where $v\_sk$ is the message coming from the $k^{th}$ bit-node.

In this regard, each check-node 520 collects all transmitted messages, except from bit-node 'i' 610, which was used to compute $c\_i$ 620 and is returned to the $i^{th}$ bit-node 610.

This DE process is repeated, i.e. it follows the same iterative process but instead of the (LLR) messages being propagated, the densities of the messages propagate through the graph. At the next iteration, the bit-nodes compute the message to be sent to the check-node as follows. Suppose that the set of check-nodes connected to that bit-node is defined by P={p1, p2, ... .pdv}, it is necessary to compute the message that that bit-node sends to the $1^{th}$ check-node (where '1' $\in$ (1, ...dv)). The message $v\_1$ is given by the sum of all the incoming messages, except from the message coming from the $1^{th}$ check-node, that is:

$$v\_1=c\_0+c\_p1+c\_p2+..+c\_\{p1\text{-}1\}+c\_\{p1\text{+}1\}+..+ c\_pdv \qquad [2]$$

Where $c\_pk$ is the message coming from the $k^{th}$ check-nodes and $c\_0$ is the initial message coming form the channel (the channel output). This procedure is done in parallel for all the bit-nodes and the check-nodes.

The preferred embodiment of the present invention utilises Density Evolution (DE), as DE obtains a track of the densities of messages exchanged between nodes as they propagate through the graph. It is known that DE provides exact results for an infinite length of the code. However, in the case of finite length codes, the inventors of the present invention have found that DE provides a good estimate of the convergence likelihood of the decoding process. Notably, using a DE enables a good estimate to be obtained, as the finite length code is cyclic in its graph, whereas the corresponding infinite length code is cycle free.

As a result, when it is determined that the DE will not converge for a corresponding infinite length code, it is guaranteed that the real iterative decoder will not converge for a finite length code.

It is envisaged that the inventive concepts described herein can be applied to any mechanism that provides a-priori information about the convergence of the decoder, and is not limited to the use of Density Evolution.

Thus, in summary, an embodiment of the present invention consists of adding a derivation of the Density Evolution prior to decoding the received information. This derivation triggers the real iterative decoding when it converges. Alternatively, if the derivation guarantees that there will be no convergence of the Density Evolution, i.e. the codeword will not be correctly decoded, and then the iterative decoding operation is not performed until a re-transmission of the data block(s) is received.

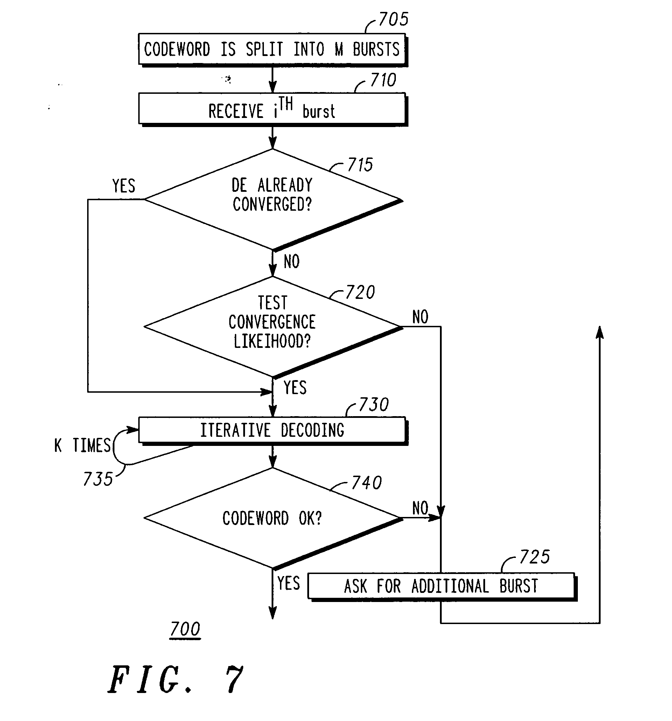

In order to quantify the improvements proposed, let us consider applying the inventive concepts in an HARQ Incremental Redundancy scheme, as described with regard to the flowchart 700 of FIG. 7. The information message is encoded using Turbo Codes or LDPC with length 'n' and split into 'M' bursts, as shown in step 705. As described, the transmitter starts sending a first burst/ initial message. The decoder receives the $i^{th}$ burst, in step 710, and determines whether the DE has already converged, as shown in step 715. If the DE has not already converged, in step 715, a determination is made as to whether it is likely that the DE will subsequently converge, as shown in step 720. If it is determined that the DE is unlikely to converge, in step 720, the process immediately requests a re-transmission of the burst, as shown in step 725. A re-transmission is requested as the non-convergence of the DE attests that the iterative decoding will not converge. In an Incremental Redundancy system, the additional burst will contain more redundancy.

If it is determined that the DE is likely to converge, in step 720, the process commences iterative decoding, in step 730, because the DE convergence shows that iterative decoding is likely to converge too. The iterative decoding operation occurs 'k' times, as shown in step 735.

If the process is able to decode the complete codeword, the process delivers the codeword to the user, as shown in step 740. However, if the decoder is unable to decode the complete codeword, the decoder stores the received burst and asks, via a negative acknowledgment, for a re-transmission of the burst with more redundancy, as shown in step 725.

It should be noted that in this case (i.e. DE convergence but non-convergence of the iterative decoder), it is not necessary to test the DE convergence any more (i.e. test for the considered codeword). Thus, when the additional burst is received, step 715 directly moves to step 735. Therefore, step 715 focuses on DE convergence, which provides only an indicator of the convergence likelihood of the real decoder, in step 730. DE convergence shows that the real iterative decoder has a chance to converge. Non-convergence of the DE indicates that there is no chance of the real decoder converging. Moreover, once the DE has converged, it is not necessary to do this test again, as subsequent transmissions include additional redundancy, thereby increasing the convergence likelihood.

Obviously, it is interesting to a receiver designer to evaluate any additional cost consequence of applying the additional step of a DE-based convergence likelihood test. Therefore, an example scenario is described below and the performance cost compared with the processing cost of performing the iterative decoder operation, irrespective of whether or not it is determined whether the decoder operation will converge.

If the complexity of BP decoder is defined as 'C_BP', it means that after the reception of 'm' bursts:

$$BP = C\_BP*m \tag{3}$$

Where BP is the total complexity of the iterative decoding technique (i.e. Belief Propagation).

As described above, DE is a useful mechanism to evaluate the performance of infinite length codes, as it provides information about the convergence of a finite-length BP decoder. This is confirmed in the paper titled "The Capacity of Low-Density Parity-Check Codes Under Message Passing Decoding" authored by T.J. Richardson and R. L Urbanke. In the paper titled "On the Construction of Some Capacity-Approaching Coding Scheme", authored by S. Y Chung in a PhD Thesis, MIT, September 2000, a description of the DE convergence performance for small BER is described.

Notably, the inventors of the present invention have recognised an opportunity to use such a DE convergence performance, in improving an operation of iterative decoders. Thus, when DE converges to a fixed point less then '1' (i.e. the decoder has insufficient information from which to decode the infinite length code), there is little hope that the finite length decoder will yield small BER. Therefore, the receiver does not even try to run the BP decoder, and asks for new redundancy (i.e. additional error correction applied to the previously sent data).

Let us assume the same channel characteristic as before, where there is correct decoding after m bursts, the following definition applies:

$$m\_nc <= m \tag{4}$$

Where 'm' is the number of bursts necessary to have Belief Propagation (i.e. real decoding) convergence. M_nc is the number of bursts necessary to have DE converged. If we define the complexity of the Density Evolution computation as 'C_DE', the computation utilizing the proposed inventive concepts yields:

$$PI = C\_DE*m\_nc + (m-m\_nc+1)*C\_BP \tag{5}$$

It is noteworthy that, once the DE has converged, it will necessarily converge when new bursts arrive. As a result, once it has converged, it is not necessary to compute it again.

It can be shown that the complexity of the present invention (PI) is significantly less than the known technique (BP). Hence, PI<<BP demonstrates the advantages in terms of speed and complexity achieved by the proposed algorithm.

Let us therefore define an approximation of the complexity, in terms of the number of multiplication operations. Two cases can then be compared: a first case where a Density Evolution test is applied prior to a real iterative decoder, as described in the present invention; and a second case using an iterative decoding algorithm on its own.

The graph that represents the code may be defined by both the bit-node degree sequence distribution $\lambda = (\lambda\_1, \lambda\_2 ... \lambda\_dv)$ and the parity check-nodes degree distribution $\rho = (\rho\_1, ... ., \rho\_dc)$. Here, $N*\lambda\_i$ defines the number of bit-nodes connected to 'i' edges in the graph, 'N' is the number of bit-nodes, and dv (dc) is the maximum degree of variable node (check-node). Thus, the number of different variable nodes (check-nodes) ddv (ddc) is bounded by dv (dc).

The complexity of the DE approach is proportional to the product of 'dc' and 'dv' for a single iteration, i.e.:

$$C\_DE \cong 4 \cdot dv \cdot dc \cdot n\_DE \qquad [6]$$

Where 'n_DE' is the number of iterations needed to detect whether Density Evolution converges or not. Defining 'n_Demax' as the maximum allowed number of iterations, the calculation yields:

$$C\_DE \cong 4 \cdot dv \cdot dc \cdot n\_Demax \qquad [7]$$

It is known that, in general, irregular LDPC has the following values: $ddv \cong 10\text{-}15$ and $ddc \cong 2\text{-}3$.

In the case of the Iterative Decoding the complexity can be computed in terms of number of multiplications, exponential and logarithm computations. Since we can say that exponential or logarithm operations are more complex than multiplications, it is easy to show that:

$$C\_BP \cong 9 \cdot n\_edges \cdot n\_BP \qquad [8]$$

Where 'n_edges' is the number of edges in the graphs (in general this is a very high number when considering that a normal LDPC's length is N=5000 to 10000) and 'n_BP' is the number of iterations necessary for the iterative decoding algorithm to decide if the frame will converge or not.

Also, in that case, a maximum number of iterations 'n_Bpmax' yield:

$$C\_BP \cong 9 \cdot n\_edges \cdot n\_Bpmax \qquad [9]$$

If we now define:

$$n\_it = n\_DEmax = n\_Bpmax \qquad [10]$$

and substituting into [3] and [4], we obtain:

$$BP = m \cdot C\_BP \cong m \cdot 9 \cdot n\_edges \cdot n\_it \qquad [11]$$

And

$$PI = 4 \cdot dc \cdot dv \cdot n\_it \cdot m\_nc + (m - m\_nc) \cdot 9 \cdot n\_edges \cdot n\_it \qquad [12]$$

Since, $4 \cdot dc \cdot dv \ll 9 \cdot n\_edges$, it is clear that the additional complexity associated with introducing a convergence likelihood test of the present invention is minimal compared to the processing time and power savings of avoiding performing an iterative decoding operation.

In practice, using an optimised Belief Propagation algorithm, even with the inclusion of an optional iterative decoding process based on Cross Entropy for turbo decoding, the inventors of the present invention have identified that the gain provided by the method is approximately 15% in terms of running time. This evaluation is based on simulation time on the same computer, with and without the method and is directly linked with the gain in terms of number of operations.

Although the preferred embodiment of the present invention is described with reference to a BP algorithm based on Cross Entropy, it is envisaged that other methods may be used, for example methods based on CRC for example as described by R.Y. Shao, S. Lin, M.P.C Fossorier, in the paper titled "Two simple stopping criteria".

It will be understood by a skilled artisan that the inventive concepts can be applied in any modem (wireless or wired) that includes an iterative decoder. For example, it is envisaged that 3G (and beyond 3$^{rd}$ generation (B3G) including 4G) communication units, using turbo codes and iterative decoders may utilize the inventive concepts described herein. It is also within the contemplation of the invention that the inventive concepts hereinafter described are equally applicable to other wireless communication systems, for example, GPRS (Generalized Packet Radio Service), or Edge, or 802.11x family of systems.

In conclusion, it will be understood that the above described inventive concepts, or at least embodiments thereof, tend to provide the following advantages, singly or in combination:

(i) It prevents a receiver from performing wasteful (in a processing power and/or time sense) iterative decoding operations.
(ii) The overall delay in a receiver iteratively decoding received data is reduced.
(iii) The prior DE test may also provide a rough approximation of the frame error rate (FER) prior to performing a real decoding operation.

Whilst the specific and preferred implementations of the embodiments of the present invention are described above, it is clear that one skilled in the art could readily apply variations and modifications of such inventive concepts.

Thus, a method of decoding one or more data blocks, a communication unit and a communication system, have been described, whereby the disadvantages associated with known prior art arrangements have been substantially alleviated.

**Claims**

1. A method (400, 700) for receiving one or more data blocks in a data communication system, the method comprising the step of:

   receiving one or more data blocks at a receiving communication unit;
   the method **characterised by** the steps of:

      determining (410) a-priori whether an iterative decoding operation of said one or more received data blocks is likely to converge; and
      requesting (420), by said receiving unit in response to determining that an iterative decoding operation is unlikely to converge, a re-transmission (430) of said one or more data blocks.

2. The method (400, 700) for receiving one or more data blocks according to Claim 1, wherein in response to a determination by said receiving unit that an iterative decoding operation is likely to converge, performing an iterative decoding operation (415).

3. The method (400, 700) for receiving one or more data blocks according to Claim 2, wherein said step of performing an iterative decoding operation (415) is dependent upon said iterative decoding operation being capable of graphical representation.

4. The method (400, 700) for receiving one or more data blocks according to any preceding Claim, wherein said step of determining comprises performing a density evolution analysis on said received data block.

5. The method (400, 700) for receiving one or more data blocks according to any preceding Claim, wherein the iterative decoding scheme is a hybrid automatic repeat request (ARQ) scheme.

6. The method (400, 700) for receiving one or more data blocks according to any preceding Claim, wherein the iterative decoding scheme uses an incremental redundancy scheme.

7.  The method (400, 700) for receiving one or more data blocks according to any preceding Claim, wherein the iterative decoding scheme comprises turbo decoding or low density parity check.

8.  The method (400, 700) for receiving one or more data blocks according to any preceding Claim, wherein the data communication system is a 3GPP or UMTS communication system.

9.  A communications system adapted to support the method of any of the preceding Claims.

10. A communications unit (300) adapted to support the method of any of preceding Claims 1 to 8.

11. A storage medium storing processor-implementable instructions for controlling a processor to carry out the method of any of Claims 1 to 8.

12. A communication unit (300) for receiving one or more data packets in a data communication system, the communication unit (300) comprising:

    a receiver receiving one or more data blocks;
    the communication unit (300) **characterised by**:

       a signal processor (308), operably coupled to said receiver, configured to determine (410) a-priori whether an iterative decoding operation to be performed on said one or more data blocks is likely to converge, and, in response to determining that an iterative decoding operation is unlikely to converge, requests a re-transmission of said one or more data blocks.

13. The communication unit (300) according to Claim 12, wherein said communication unit (300) employs a hybrid automatic repeat request scheme.

14. The communication unit (300) according to Claim 12 or 13, wherein said communication unit (300) is a Node-B or a UE configured for operation on a UMTS or 3GPP wireless communication system.

**Amended claims in accordance with Rule 86(2) EPC.**

1. A method (400, 700) for receiving one or more data blocks in a data communication system, the method comprising the step of:

   receiving one or more data blocks at a receiving communication unit; and
   decoding the received data blocks using an iterative decoding operation;

   **characterised by** the steps of:

   before performing the iterative decoding of a received data block, determining (410) whether the iterative decoding operation of the data block is likely to converge;
   requesting (420), by said receiving unit in response to determining that an iterative decoding operation is unlikely to converge, a re-transmission (430) of said one or more data blocks; and
   in response to a determination by said receiving unit that an iterative decoding operation is likely to converge, performing an iterative decoding operation (415).

2. The method (400, 700) for receiving one or more data blocks according to Claim 1, wherein said step of determining comprises performing a density evolution analysis on said received data block.

3. The method (400, 700) for receiving one or more data blocks according to Claim 1 or 2, wherein the iterative decoding scheme is a hybrid automatic repeat request scheme.

4. The method (400, 700) for receiving one or more data blocks according to any preceding Claim, wherein the iterative decoding scheme uses an incremental redundancy scheme.

**5.** The method (400, 700) for receiving one or more data blocks according to any preceding Claim, wherein the iterative decoding scheme comprises turbo decoding or low density parity check.

**6.** A communications unit (300) adapted to support the method of any preceding Claim and comprising means (206, 302) for receiving said one or more data blocks, means (304) for determining whether the iterative decoding operation of a received data block is likely to converge before the iterative decoding of the data block is performed, means (310) for selectively decoding the received data blocks using an iterative decoding operation in response to a determination that an iterative decoding operation is likely to converge, and means (430) for requesting re-transmission in response to a determination that an iterative decoding operation is unlikely to converge.

**7.** The communication unit (300) according to Claim 6, wherein said communication unit (300) employs a hybrid automatic repeat request scheme.

**FIG. 1**

-PRIOR ART-

**FIG. 2**

206
RECEIVER
FRONT-END
CIRCUITRY

302
DEMODULATOR

304
DECISION
FUNCTION

312
SISO
DECODER

322
DE-LEAVING

INTERLEAVING

310

324

SISO
DECODER

314                    ITERATIVE DECODER

208

300                    SIGNAL PROCESSOR

## FIG. 3

405
RECEIVE INFORMATION

410
TEST
CONVERGENCE
LIKEIHOOD?                    NO

YES        415
ITERATIVE DECODING

K TIMES

420

425
CODEWORD OK?                    NO

YES        430
ASK FOR RETRANSMISSION

400

## FIG. 4

FIG. 5

FIG. 6

```
                                                    ┌─705
                        ┌──────────────────────────────────┐
                        │  CODEWORD IS SPLIT INTO M BURSTS  │
                        └──────────────────────────────────┘
                                         │        ┌─710
                        ┌──────────────────────────────────┐
                        │         RECEIVE iᵀᴴ burst         │
                        └──────────────────────────────────┘
                                         │
                                         ▼
                                     ╱───────╲  ┌─715
                   YES            ╱   DE ALREADY  ╲
              ◄─────────────────◄    CONVERGED?    ╲
              │                     ╲             ╱
              │                       ╲─────────╱
              │                           │ NO
              │                           ▼
              │                       ╱───────╲  ┌─720
              │                    ╱     TEST     ╲        NO
              │                   ╱  CONVERGENCE   ╲────────────►
              │                   ╲  LIKEIHOOD?   ╱
              │                     ╲           ╱
              │                       ╲───────╱
              │                           │ YES
              └──────────────────────────►│
                                          ▼    ┌─730
                        ┌──────────────────────────────────┐
                   ┌───►│        ITERATIVE DECODING         │
          K TIMES  │    └──────────────────────────────────┘
              735 ─┘                      │
                                          ▼
                                     ╱───────╲  ┌─740
                                  ╱             ╲      NO
                                 ╱  CODEWORD OK?  ╲───────►
                                 ╲               ╱
                                   ╲           ╱
                                     ╲───────╱    ┌─725
                                        │ YES  ┌────────────────────────┐
                                        │      │  ASK FOR ADDITIONAL BURST │
                                        ▼      └────────────────────────┘
                      700
```

$$\underline{700}$$

# FIG. 7

## EUROPEAN SEARCH REPORT

**European Patent Office**

**Application Number**

EP 03 29 0328

### DOCUMENTS CONSIDERED TO BE RELEVANT

| Category | Citation of document with indication, where appropriate, of relevant passages | Relevant to claim | CLASSIFICATION OF THE APPLICATION (Int.Cl.7) |
|---|---|---|---|
| X | US 2001/004761 A1 (ZEHAVI EPHRAIM) 21 June 2001 (2001-06-21) * abstract * * page 4, paragraphs 45,46 * * figure 7 * | 1,9-12 | H04L1/18 H04L1/00 H03M13/00 |
| A | EP 1 193 881 A (SONY CORP) 3 April 2002 (2002-04-03) * abstract * * figure 4 * | 1-14 | |
| A | WO 01 63869 A (NOKIA MOBILE PHONES LTD ;PUKKILA MARKKU (FI); VILPPONEN HANNU (US)) 30 August 2001 (2001-08-30) * abstract * * figures 1-3 * | 1-14 | |
| A | WO 01 37433 A (MOTOROLA INC) 25 May 2001 (2001-05-25) * figure 2 * | 1-14 | |
| D,A | RICHARDSON T J ET AL: "The capacity of low-density parity-check codes under message-passing decoding" IEEE TRANSACTIONS ON INFORMATION THEORY, IEEE INC. NEW YORK, US, vol. 47, no. 2, February 2001 (2001-02), pages 599-618, XP002228426 ISSN: 0018-9448 * the whole document * | 1-14 | **TECHNICAL FIELDS SEARCHED (Int.Cl.7)** H04L H03M |

The present search report has been drawn up for all claims

| Place of search | Date of completion of the search | Examiner |
|---|---|---|
| THE HAGUE | 8 August 2003 | Toumpoulidis, T |

CATEGORY OF CITED DOCUMENTS

X : particularly relevant if taken alone
Y : particularly relevant if combined with another document of the same category
A : technological background
O : non-written disclosure
P : intermediate document

T : theory or principle underlying the invention
E : earlier patent document, but published on, or after the filing date
D : document cited in the application
L : document cited for other reasons

& : member of the same patent family, corresponding document

EPO FORM 1503 03.82 (P04C01)

## ANNEX TO THE EUROPEAN SEARCH REPORT
## ON EUROPEAN PATENT APPLICATION NO.

EP 03 29 0328

This annex lists the patent family members relating to the patent documents cited in the above-mentioned European search report.
The members are as contained in the European Patent Office EDP file on
The European Patent Office is in no way liable for these particulars which are merely given for the purpose of information.

08-08-2003

| Patent document cited in search report | | Publication date | Patent family member(s) | | Publication date |
|---|---|---|---|---|---|
| US 2001004761 | A1 | 21-06-2001 | US 6212659 B1 | | 03-04-2001 |
| | | | AU 751048 B2 | | 08-08-2002 |
| | | | AU 7802598 A | | 30-12-1998 |
| | | | CN 1262004 T | | 02-08-2000 |
| | | | EP 0985292 A2 | | 15-03-2000 |
| | | | JP 2002501707 T | | 15-01-2002 |
| | | | WO 9854866 A2 | | 03-12-1998 |
| EP 1193881 | A | 03-04-2002 | JP 2002111512 A | | 12-04-2002 |
| | | | EP 1193881 A2 | | 03-04-2002 |
| | | | US 2002062468 A1 | | 23-05-2002 |
| WO 0163869 | A | 30-08-2001 | FI 20000443 A | | 26-08-2001 |
| | | | AU 3931801 A | | 03-09-2001 |
| | | | EP 1258121 A1 | | 20-11-2002 |
| | | | WO 0163869 A1 | | 30-08-2001 |
| | | | US 2001017904 A1 | | 30-08-2001 |
| WO 0137433 | A | 25-05-2001 | US 6308294 B1 | | 23-10-2001 |
| | | | BR 0015558 A | | 09-07-2002 |
| | | | CA 2391623 A1 | | 25-05-2001 |
| | | | EP 1247345 A1 | | 09-10-2002 |
| | | | JP 2003515268 T | | 22-04-2003 |
| | | | WO 0137433 A1 | | 25-05-2001 |

For more details about this annex : see Official Journal of the European Patent Office, No. 12/82